(19)

**Europäisches Patentamt**
**European Patent Office**
**Office européen des brevets**

(11)  **EP 4 672 238 A1**

(12)  **EUROPEAN PATENT APPLICATION**

(43) Date of publication:
**31.12.2025  Bulletin 2026/01**

(21) Application number: **25185581.3**

(22) Date of filing: **26.06.2025**

(51) International Patent Classification (IPC):
**G10L 21/0208** (2013.01)   **G10L 25/78** (2013.01)
**H03G 3/32** (2006.01)

(52) Cooperative Patent Classification (CPC):
**G10L 21/0208; G10L 25/78; H03G 3/32;
H03G 3/342**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority:  **26.06.2024  US 202418755240**

(71) Applicant: **Harman International Industries,
Incorporated
Stamford, CT 06901 (US)**

(72) Inventor: **SHAH, Ritesh Pankajkumar
560067 Chanasandra (IN)**

(74) Representative: **Rummler, Felix
Maucher Jenkins
Liebigstraße 39
80538 München (DE)**

(54)  **SYSTEM AND METHOD FOR AUTOMATIC ATTENUATION OF ENTERTAINMENT AUDIO
BASED ON BACKGROUND AUDIO**

(57)     In at least one embodiment, an audio system is provided. one or more microphones capture an audio input signal including at least one of captured entertainment audio and a speech output from at least one occupant positioned in a vehicle. An at least one audio controller is programmed to transmit first entertainment audio into a cabin of the vehicle via one or more loudspeakers. The at least one audio controller is further programmed to receive the audio input signal from the one or more microphones and to receive a reference signal indicative of the first entertainment audio that is being transmitted into the cabin of the vehicle. The at least one controller is further programmed to apply to the reference signal to the captured entertainment audio to provide the speech output and to compare a loudness of the speech output to a loudness threshold.

*Fig-1*

EP 4 672 238 A1

**Description**

TECHNICAL FIELD

Aspects disclosed herein generally relate to a system and method for automatic attenuation of entertainment audio based on background audio. These aspects and others will be discussed in more detail herein.

BACKGROUND

It is generally common that occupants talk to one another inside a vehicle. It is also common for occupants to listen to music as a higher volume at the same time. Whenever occupants listen to entertainment audio at a high-volume level and one or more occupants positioned within the vehicle talks to one another other loudly, this makes it difficult for other occupants (e.g., including driver) positioned within the vehicle to listen to entertainment audio properly and also to hear is being spoken by other occupants in the vehicle. The occupants in the vehicle cannot listen to any of the audio properly which leads to a degraded listening experience.

In these instances, the driver may need to manually decrease the volume of the entertainment audio that is being played back in order to properly hear the occupant in the vehicle who is speaking. Once the dialogue has come to an end, the driver may then need to manually increase the volume of the entertainment audio back to its original level. This increases driver distraction and risk for overall safety.

SUMMARY

In at least one embodiment, an audio system including one or more microphones and at least one audio controller is provided. The one or more microphones capture an audio input signal including at least one of captured entertainment audio and a speech output from at least one occupant positioned in a vehicle. The at least one audio controller is programmed to transmit first entertainment audio into a cabin of the vehicle via one or more loudspeakers. The at least one audio controller is further programmed to receive the audio input signal from the one or more microphones and to receive a reference signal indicative of the first entertainment audio that is being transmitted into the cabin of the vehicle. The at least one controller is further programmed to apply to the reference signal to the captured entertainment audio to at least partially remove the captured entertainment audio from the audio input signal to provide the speech output and to compare a loudness of the speech output to a loudness threshold after applying the reference signal to the captured entertainment audio. The at least one audio controller is further programmed to attenuate the first entertainment audio based at least on a comparison of the loudness of the speech output to the loudness threshold.

In at least another embodiment, a method is provided that includes receiving an audio input signal including at least one of captured entertainment audio and a speech output from at least one occupant positioned in a vehicle and transmitting first entertainment audio into a cabin of the vehicle via one or more loudspeakers. The method further includes receiving, via at least one audio controller, a reference signal indicative of the first entertainment audio that is being transmitted into the cabin of the vehicle and applying the reference signal to the captured entertainment audio to at least partially remove the captured entertainment audio from the audio input signal to provide the speech output. The method further includes comparing a loudness of the speech output to a loudness threshold after applying the reference signal to the captured entertainment audio and attenuating the first entertainment audio based at least on a comparison of the loudness of the speech output to the loudness threshold.

In at least another embodiment, a computer-program product embodied in a non-transitory computer readable medium that is stored in memory and that is programmed and executable by at least one audio controller in an audio system is provided. The computer-program product includes instructions to receive an audio input signal including at least one of captured entertainment audio and a speech output from at least one occupant positioned in a vehicle and to transmit first entertainment audio into a cabin of the vehicle via one or more loudspeakers. The computer program product includes instructions to receive a reference signal indicative of the first entertainment audio that is being transmitted into the cabin of the vehicle and to apply the reference signal to the captured entertainment audio to at least partially remove the captured entertainment audio from the audio input signal to provide the speech output. The computer program product includes instructions to compare at least one of a loudness of the speech output to a loudness threshold or a volume of the first entertainment audio to the predetermined audio level after applying the reference signal to the captured entertainment audio and to attenuate the first entertainment audio based on a comparison of the loudness of the speech output to the loudness threshold.

BRIEF DESCRIPTION OF THE DRAWINGS

The embodiments of the present disclosure are pointed out with particularity in the appended claims. However, other features of the various embodiments will become more apparent and will be best understood by referring to the following detailed description in conjunction with the accompany drawings in which:

FIGURE 1 generally depicts a system for automatic attenuation of entertainment audio based on speech detected in a vehicle in accordance with one embodiment;

FIGURE 2 generally depicts the system of FIGURE 1 that enables the playback of entertainment audio based on a lack of speech being detected or a speed of the speech being spoken is below a predetermined speed;

FIGURE 3 generally depicts a method for automatic attenuation of the entertainment audio based on the detected speech in the vehicle in accordance with one embodiment; and

FIGURE 4 generally depicts a more detailed diagram of the energy-based voice activity detection (VAD) block in accordance with one embodiment.

DETAILED DESCRIPTION

As required, detailed embodiments of the present invention are disclosed herein; however, it is to be understood that the disclosed embodiments are merely exemplary of the invention that may be embodied in various and alternative forms. The figures are not necessarily to scale; some features may be exaggerated or minimized to show details of particular components. Therefore, specific structural and functional details disclosed herein are not to be interpreted as limiting, but merely as a representative basis for teaching one skilled in the art to variously employ the present invention.
Aspects disclosed herein provide a system and a method for automatic attenuation of entertainment audio based on background audio. For example, various aspects disclosed herein may remove manual intervention/effort from a vehicle occupant to increase/decrease the entertainment volume to hear (or listen) speech spoken by one or more passengers in the vehicle properly. The disclosed aspects also indirectly improve hearing important information from other person in-car when entertainment audio is playing at higher volume.
In general, the disclosed system and method may attenuation the entertainment audio based on detected speech in the vehicle when only the entertainment audio is being played back in the vehicle. If any other source of audio (e.g., call, virtual reality (VR), notifications etc.) is active, then system and method may not attenuate entertainment audio. The disclosed system and method can employ a response time when attenuating the entertainment audio for the person listening to the other occupant who is speaking in the vehicle. Similarly, the disclosed system and method may be beneficial to reduce driver distraction in terms of not having to manually reduce the entertainment audio when an occupant is speaking in the vehicle particularly in moments when traffic conditions change frequently and/or when roads are changing quickly such as hilly or mountainous roads. In addition, by attenuating the entertainment audio when an occupant is speaking, this aspect may provide comfort for the human ear. It is recognized that the features of attenuating the entertainment audio when an occupant is speaking in the vehicle may be offered as a premium feature for an Original Equipment Manufacturer (OEM). The feature may also be offered by an OEM as a subscription-based feature.

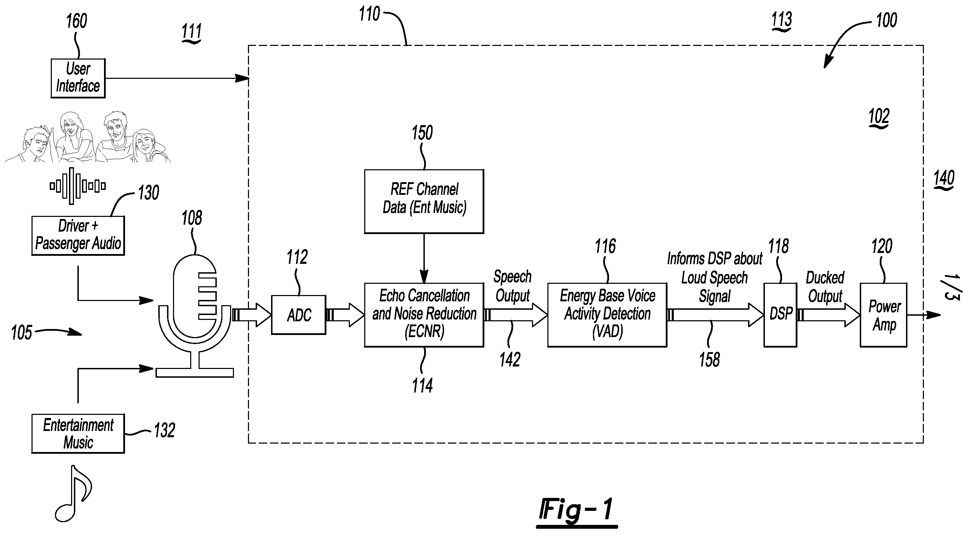

FIGURE 1 generally depicts a system 100 for automatic attenuation of entertainment audio based on speech detected in a vehicle 102 in accordance with one embodiment. In general, the system 100 is configured to detect speech in the vehicle and to attenuate the level of entertainment audio that is being played in the vehicle 102 while the speech is detected. For example, the system 100 includes one or more microphones 108 and at least one audio controller 110 (the "controller 110" hereafter) and at least one memory device 113 (e.g., the memory 113). The memory 111 may be operably coupled to the controller 110 such that the controller 110 can execute code stored on the memory 111 for executing the operations noted herein.
The controller 110 generally includes an analog to digital converter ("ADC") 112, an Echo Cancellation and Noise Reduction (ECNR) block 114, an Energy Base Voice Activity Detection (EBVAD) block 116, at least one digital signal processing block (DSP) 118 (the DSP 118), and a power amp 120. The one or more microphones 108 may be positioned anywhere within a cabin 111 of the vehicle 102. In one example, at least one microphone 108 may be positioned proximate to a driver in the vehicle 102 and is configured to receive an audio input signal 105. The audio input signal 105 may include spoken audio or speech-based audio 130 and/or entertainment audio 132. In particular, the microphone 108 may be configured to detect the speech-based audio 130 that comprise speech that is spoken in the cabin 111 between the driver and any one or more passengers in the vehicle 102. Similarly, the microphone 108 may be configured to also capture the entertainment audio 132 that is generated by the controller 110. One or more loudspeakers 140 (the "loudspeaker 140" hereafter) may be positioned within the cabin 111 of the vehicle 102 to transmit the entertainment audio 132 (i.e., first entertainment audio 132) before being received by the microphone 108). In particular, the microphone 108 may capture the entertainment audio 132 (i.e., captured entertainment audio 132 after transmission from the loudspeaker 140.
The microphone 108 provides the speech-based audio 130 and/or the entertainment audio 132 to the controller 110 in an analog format. The ADC 112 of the controller 110 converts the analog based speech-based audio 130 and the analog based entertainment audio 132 into a digital format. The ECNR block 114 may remove unnecessary noise, such as, for example, wind noise, engine noise, etc. that may be present exterior to the vehicle 102 and that may be captured on the speech-based audio 130 and entertainment audio 132.

A reference channel data signal (or reference signal) 150 may be provided to the ECNR block 114. In this case, the reference signal 150 includes the entertainment audio 132 that is being transmitted by the loudspeaker 140. In this regard, the ECNR block 114 may cancel the entertainment audio 132 that is present on the reference signal 150 and the captured entertainment audio 132 provided by the microphone 108. Without the ECNR block 112, the controller 102 may consider or determine that aspects of the entertainment audio 130 that includes speech-based audio (e.g., vocals, etc.) may represent aspects of the speech-based audio 130. In this regard, the controller 110 may not accurately discern between the speech-based audio 130 that is spoken data between the driver and/or one or more occupants in the vehicle 102 and that may be present on the speech-based data of the entertainment audio 132.

The EBVAD block 116 receives an output 142 (or speech output 142) from the ECNR block 114. In general, the speech may be characterized as a discontinuous signal since information is carried or present only when someone is talking. The EBVAD block 116 detects the speech based on an overall loudness on the speech output 142 provided by the ECNR block 114. The EBVAD block 116 may detect speech based on, *inter alia,* its unique speed or frequency when included on the audio input signal. The manner in which the speech is detected will be discussed in more detail below. The EBVAD block 116 compares the loudness of the speech output 142 to a loudness threshold. In this regard, the loudness threshold of the EBVAD block 116 may be configurable (or adjustable) by the driver or occupant in the vehicle 102. Similarly, the driver may also configure or program the amount of volume that is attenuated on the entertainment audio 132 when speech is detected and that exceeds the loudness threshold.

In another example, the driver may also configure, program, or establish a predetermined volume threshold which corresponds to the volume level for the entertainment audio 132 in which it is desirable to attenuate the entertainment audio 132 in response to the detected speech exceeding the loudness threshold. For example, in some cases, if the controller 110 is playing the entertainment audio 132 at a volume that is less than the predetermined volume threshold, the controller 110 may not attenuate the entertainment audio 132 even if the loudness of the detected speech is greater than the loudness threshold. In this case, given that the overall volume of the entertainment audio 132 is considered low, it may be assumed that the driver and the occupant can hear the spoken speech and hence there is no need to attenuate the entertainment audio 132 given that such audio 132 is played back 132 at a volume that does not interfere with the driver and/or occupant's ability to hear the spoken speech.

In another example, the loudness threshold established for detecting speech and/or the amount of volume that is attenuated (or attenuation volume) for the entertainment audio 132 when speech is detected may also be configurable by an Original Equipment Manufacturer (OEM). In this instance, the loudness threshold and/or the attenuation volume may be set to a single level that does not change. Similarly, the predetermined volume threshold may be configurable OEM. In response to the EBVAD block 116 determining the loudness of the speech data on the speech-based audio 130 is greater than the loudness threshold and that the volume of the entertainment audio 132 is greater than the predetermined volume threshold, the EBVAD block 116 may attenuate the entertainment data that is to be played back by the loudspeaker 114 by a predetermined attenuation level.

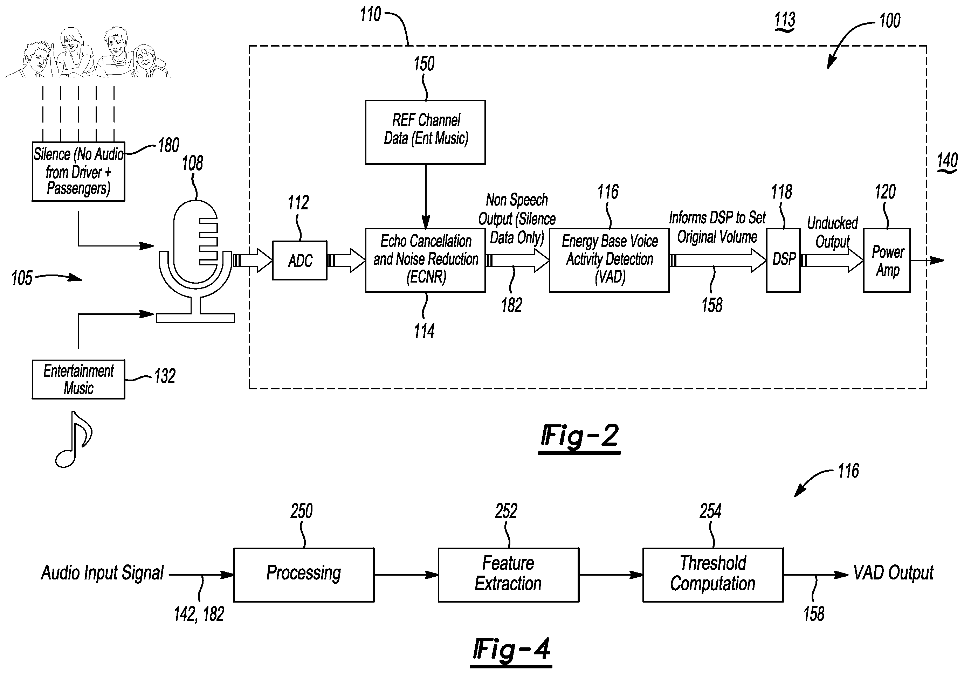

For example, the EBVAD block 116 may reduce an overall volume of the entertainment data to be played back by the loudspeaker 114 in response to the loudness of the speech data exceeding the loudness threshold and the volume of the entertainment audio 132 that is being played back is greater than the predetermined volume threshold by transmitting a control signal 158 to the DSP 118. The control signal 158 in this case informs the DSP 118 about a loud speech signal being present on the captured speech-based audio 130. In turn, the DSP 118 may attenuate the volume of the audio output provided to the loudspeaker 140 which is then provided as the entertainment data 132 in the cabin 111. It is recognized that once occupants positioned in the vehicle 102 talk to one another either at a decreased volume (e.g., such as whispering, murmuring, etc.) or completely stops to one another loudly, then the controller 110 (e.g., the EBVAD block 116) locates the silence for certain durations and controls the DSP 118 to un-duck the volume (or removed the attenuated condition) and enable the controller 110 to provide the entertainment data 132 at it's original volume level. This aspect will be discussed in more detail in connection with FIGURE 2. If the loudness of the speech output 142 is below the loudness threshold and/or the volume of the entertainment audio 132 is below the predetermined volume threshold, then the EBVAD block 116 transmits the control signal 158 to the DSP 118 to refrain from attenuating the volume of the entertainment audio that is played back from the loudspeaker 140.

As noted above, in the event the loudness threshold is configurable by the driver and/or occupants, a user interface 160 may be provided to enable the driver and/or occupant to select and transmit the selected loudness threshold to the controller 110. Similarly, the user interface 160 may be provided to enable the driver and/or the occupant to establish the amount of attenuation that is applied to the entertainment audio 130 when the detected speech exceeds the loudness threshold. In addition, the user interface 160 may be provided to enable the driver and/or the occupant to establish or program the predetermined volume threshold for the entertainment audio 132. It is recognized that these configurable features may be disabled by the driver and/or occupant in the vehicle 102. FIGURE 2 depicts the system 100 in which the microphones 108 provides an audio input signal that includes silence 180 (e.g., no spoken or speech audio) provided by the driver and/or the passenger and the entertainment audio 132 as originally transmitted by the loudspeaker 140 via the controller 110. In this case, the microphone 108 provides the entertainment audio 132 and the silence 180 to the controller 110. The ADC 112 converts the analog based entertainment audio 132 into a digital format. The ECNR block 114 may remove unnecessary noise, such as, for example, wind noise, engine noise, etc. that may be present exterior to the vehicle 102 and that may be captured on the entertainment audio 132.

As noted above, the reference signal 150 may be provided to the ECNR block 114. The reference signal 150 includes the entertainment audio 132 that is being transmitted by the loudspeaker 140. The ECNR block 114 may subtract the entertainment audio 132 that is present on the reference signal 150 from the captured entertainment audio 132 provided by the microphone 108 to provide a non-speech output 182.

The EBVAD block 116 receives the non-speech output 182 from the ECNR block 114 and provides the control signal 158 to inform the DSP to set the entertainment audio 132 at its originally desired volume as selected by the driver. In turn, the DSP 118 receives the control signal 158 and provides the entertainment audio 132 at an unducked level (e.g., no attenuation is applied to the entertainment audio 132). The power amp 120 provides the unducked (i.e., unattenuated) entertainment audio 132 to the loudspeakers 140. The loudspeaker 140 transmits the entertainment audio 132 into the cabin 111 at the desired volume as selected by the driver.

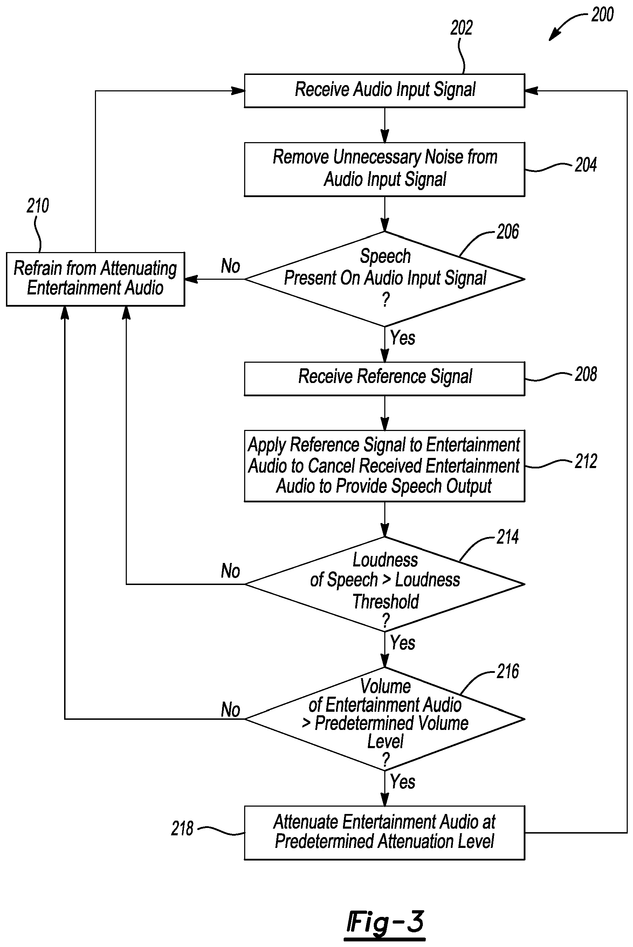

FIGURE 3 depicts a method 200 for automatic attenuation of the entertainment audio 130 based on the detected speech in the vehicle 102 in accordance with one embodiment.

In operation 202, the controller 110 receives the audio input signal 105 from one or more of the microphones 108 positioned in the vehicle 102. As noted above, the audio input signal 105 may include the speech-based audio 130 and/or the entertainment audio 132. The speech-based audio 130 may include speech that is spoken between a driver and one or more passengers in the vehicle 102. The entertainment audio 132 may initially correspond to audio data that is played back by the controller 110 via the loudspeakers 140 that is transmitted into the cabin 111 of the vehicle 102 and then subsequently captured by one or more microphones 108 positioned in the vehicle 102.

In operation 204, the controller 110 removes any unnecessary noise from the audio input signal.

In operation 206, the controller 110 determines whether the audio input signal 150 as captured by the microphones 130 includes the speech-based audio 130. The manner in which the speech may be detected by the controller 110 will be discussed in more detail in connection with FIGURE 4. If the controller 110 determines that the audio input signal 105 includes the speech-based audio 130, then the method 200 moves to operation 208. If the controller 110 determines that the audio input signal 105 does not include the speech-based audio 130, then the method 200 moves to operation 210 and the controller 110 does not attenuate the entertainment audio 132.

In operation 208, the controller 110 receives the reference signal 150 which provides an input signal indicative of the entertainment audio 130 that is being played back by the controller 110.

In operation 212, the controller 110 (i.e., the ECNR block 114) applies the reference signal 150 to the captured entertainment audio 130 to cancel the captured or received entertainment audio 130 from the ECNR block 114 to provide the speech audio 142 (or output 142 from the ECNR block 114).

In operation 214, the controller 110 ascertains an overall loudness of the speech audio 142 as provided by the ECNR block 114. The controller 110 (i.e., EBVAD block 116) compares the loudness of the speech output 142 to the loudness threshold. As noted above, the loudness threshold of the EBVAD block 116 may be configurable (or adjustable) by the driver or occupant in the vehicle 102 via the user interface 160. Alternatively, the loudness threshold may be permanently set or programmed by the Original Equipment Manufacturer (OEM). If the loudness of the speech output 142 is not greater than the loudness threshold, then the method 200 moves to operation 210. If the loudness of the speech output 142 is greater than the loudness threshold, then the method 200 moves to operation 216.

In operation 216, the controller 110 determines the volume level for the entertainment audio 132 that is being placed back. The controller 110 compares the volume of the entertainment audio 132 to the predetermined volume level for the entertainment audio 132. As noted above, the predetermined volume level may be configurable (or adjustable) by the driver or occupant in the vehicle 102 via the user interface 160. Alternatively, the predetermined volume level may be permanently set or programmed by the Original Equipment Manufacturer (OEM). If the volume of the entertainment audio 132 is greater than the predetermined volume level, then the method 200 moves to operation 218. If the volume of the entertainment audio 132 is less than the predetermined volume level, then the method 200 moves to operation 210.

In operation 210, the controller 110 refrains from attenuating the entertainment audio 130 that is provided by the loudspeakers 140 since the overall loudness of the speech output 142 is less than the loudness threshold. The captured speech-based audio 130 in the vehicle 102 is not considered loud enough to have to attenuate the entertainment audio 130. For example, consider the scenario when a small child is present in the vehicle and is unable to communicate effectively to his/her parents. In this case, the soft voice projected by the child may not exceed the loudness threshold. Here, it is not desirable to attenuate the entertainment audio 132.

Similarly, if the volume of the entertainment audio 132 is less than the predetermined volume level, then the controller 110 refrains from attenuating the entertainment audio 130. In this case, the volume of the speech that is detected in the vehicle may be sufficiently heard by other occupants over the volume of the entertainment audio 132 that is being played back in the vehicle. In addition, the controller 110 refrains from attenuating the entertainment audio that is provided by the loudspeakers 140 if no speech is detected on the audio input signal 105.

In operation 218, the controller 110 attenuates the entertainment audio 130 that will be transmitted by the loudspeakers 140 into the cabin. The driver may also configure or program the amount of volume that is attenuated on the entertainment audio 132, via the user interface 160 when speech is detected and that exceeds the loudness threshold. Alternatively, the attenuation level for the entertainment audio 132 may be permanently set or programmed by the OEM.

In general, in the event the method 200 has executed operation 218 to attenuate the entertainment audio 130 and silence is detected on the audio input signal 105, then the controller 110 may then unduck or unattenuate the playback of the entertainment audio 132. In the event, the entertainment audio is not already attenuated and if the controller 110 observes silence on the audio input signal 105, then the controller 110 continues to playback the entertainment audio 132 as is.

FIGURE 4 generally depicts a more detailed diagram of the EBVAD block 116 in accordance with one embodiment. In general, the EBVAD block 116 detects the presence or absence of human speech. The EBVAD block 116 extracts features or quantities from the audio input signal 105 (e.g., the speech output 142 or non-speech output 182) and then compares these values to a particular threshold (e.g., loudness threshold) to classify the data as speech or non-speech. In one example, the features or quantities may refer to energy, power, pitch, signal to noise ratio, etc. associated with a speech signal and any one or more of these features may be compared to various loudness thresholds associated with a predetermined energy level, a predetermined power, predetermined pitch, and/or predetermined signal to noise ratio, etc.

The block 116 includes a processing block 250, a feature extraction block 252, and a threshold computation block 254. The processing block 250 may be optional and perform additional noise reduction on the speech-based output 142 or the non-speech-based output 182. In one example, the feature extraction block 252 calculates a signal energy of the filtered output 142, 182. In general, the energy of the speech signal corresponds to a total magnitude of the signal. For audio signals, the magnitude generally corresponds to how loud the speech signal is. For the energy based VAD, the speech signal may be divided into frames where a frame comprises a unit of time such as 5ms, 10ms, etc. One method for calculating the energy of the speech signal includes determining the root mean square energy (RMSE), which corresponds to determining the square root of the average sum of the squares of the amplitude of the signal samples.

For example, the energy of a signal may be defined as:

$$\sum_n |x(n)|^2$$

$$(\text{Eq. 1})$$

The RMSE of the speech signal may be defined as:

$$\sqrt{\frac{1}{N} \sum_n |x(n)|^2}$$

$$(\text{Eq. 2})$$

The threshold computation block 254 applies a classification rule to classify information on the output 142, 182. For example, the threshold computation block 254 applies the classification rule to determine whether the audio input signal 105 includes a speech output 142 or a non-speech output 182. Thus, the threshold computation block 254 compares an energy value of the audio input signal 105 (see Eq. 2) to a predetermined energy level. The threshold computation block 254 determines that speech is present on the audio input signal 105 in response to the energy value of the audio input signal 105 exceeding the predetermined energy level. The threshold computation block 254 determines that no speech is present on the audio input signal 105 in response to the energy value of the audio input signal 105 being below the predetermined energy level.

It recognized that the controllers as disclosed herein may include various microprocessors, integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, such controllers as disclosed utilizes one or more microprocessors to execute a computer-program that is embodied in a non-transitory computer readable medium that is programmed to perform any number of the functions as disclosed. Further, the controller(s) as provided herein includes a housing and the various number of microprocessors, integrated circuits, and memory devices ((e.g., FLASH, random access memory (RAM), read only memory (ROM), electrically programmable read only memory (EPROM), electrically erasable programmable read only memory (EEPROM)) positioned within the housing. The controller(s) as disclosed also include hardware-based inputs and outputs for receiving and transmitting data, respectively from and to other hardware-based devices as discussed herein.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

**Claims**

1. An audio system comprising:

    one or more microphones configured to capture an audio input signal including at least one of a captured entertainment audio and a speech output from at least one occupant positioned in a vehicle;
    at least one audio controller programmed to:

        transmit first entertainment audio into a cabin of the vehicle via one or more loudspeakers;
        receive the audio input signal from the one or more microphones;
        receive a reference signal indicative of the first entertainment

    audio that is being transmitted into the cabin of the vehicle;

        apply to the reference signal to the captured entertainment audio to at least partially remove the captured entertainment audio from the audio input signal to provide the speech output;
        compare a loudness of the speech output to a loudness threshold after applying the reference signal to the captured entertainment audio; and
        attenuate the first entertainment audio based at least on a comparison of the loudness of the speech output to the loudness threshold.

2. The audio system of claim 1, wherein the at least one audio controller is further programmed to compare of a volume of the first entertainment audio to a predetermined volume level.

3. The audio system of claim 2, wherein the at least one audio controller is further programmed to attenuate the first entertainment audio based on the comparison of the loudness of the speech output to the loudness threshold and the comparison of the volume of the first entertainment audio to the predetermined volume level.

4. The audio system of claim 3, wherein the at least one audio controller is further programmed to attenuate the first entertainment audio in response to the loudness of the speech output exceeding the loudness threshold and the volume of the first entertainment audio exceeding the predetermined volume level.

5. The audio system of claim 2, 3 or 4, wherein the at least one audio controller is further programmed to refrain from attenuating the first entertainment audio in response to at least one of the loudness of the speech output being less than the loudness threshold or the volume of the first entertainment audio being below the predetermined volume level.

6. The audio system of any of claims 2 to 5, wherein the at least one audio controller is further programmed to receive a first signal indicative of a command to set the loudness threshold to a predetermined loudness level from a user interface.

7. The audio system of any of claims 2 to 6, wherein the at least one audio controller is further programmed to receive a first signal indicative of a command to attenuate the first entertainment audio by a predetermined attenuation level from a user interface.

8. The audio system of any of claims 2 to 7, wherein the at least one audio controller is further programmed to receive a first signal indicative of a command to set the predetermined volume level for comparison to the first entertainment audio from a user interface.

9. The audio system of any preceding claim, wherein the at least one audio controller is further programmed to determine whether the speech output is present on the audio input signal.

10. The audio system of claim 9, wherein the at least one audio controller is further programmed to refrain from attenuating the first entertainment audio in response to determining that the speech output is not present on the audio input signal.

11. The audio system of any preceding claim, wherein the at least one audio controller is further programmed to at least partially remove the captured entertainment audio from the audio input signal by applying the reference signal that is indicative of the first entertainment audio that is being transmitted into the cabin.

12. A method comprising:

receiving an audio input signal including at least one of captured entertainment audio and a speech output from at least one occupant positioned in a vehicle;
transmitting first entertainment audio into a cabin of the vehicle via one or more loudspeakers;
receiving, via at least one audio controller, a reference signal indicative of the first entertainment audio that is being transmitted into the cabin of the vehicle;
applying the reference signal to the captured entertainment audio to at least partially remove the captured entertainment audio from the audio input signal to provide the speech output;
comparing a loudness of the speech output to a loudness threshold after applying the reference signal to the captured entertainment audio; and
attenuating the first entertainment audio based at least on a comparison of the loudness of the speech output to the loudness threshold.

13. The method of claim 12 further comprising comparing a volume of the first entertainment audio to a predetermined volume level prior to attenuating the first entertainment audio.

14. The method of claim 13, wherein attenuating the first entertainment audio based at least on the comparison of the loudness of the speech output to the loudness threshold further includes attenuating the first entertainment audio based on the comparison of the loudness of the speech output to the loudness threshold and the comparison of the volume of the first entertainment audio to the predetermined volume level.

15. The method of claim 14, wherein attenuating the first entertainment audio based on the comparison of the loudness of the speech output to the loudness threshold and the comparison of the volume of the first entertainment audio to the predetermined volume level further includes attenuating the first entertainment audio in response to the loudness of the speech output exceeding the loudness threshold and the volume of the first entertainment audio exceeding the predetermined volume level.

_Fig-1_

EP 4 672 238 A1

EP 4 672 238 A1

_Fig-2_

_Fig-4_

*200*

Receive Audio Input Signal — *202*

↓

Remove Unnecessary Noise from Audio Input Signal — *204*

↓

*206* — Speech Present On Audio Input Signal ? — **No** → Refrain from Attenuating Entertainment Audio — *210*

↓ **Yes**

Receive Reference Signal — *208*

↓

Apply Reference Signal to Entertainment Audio to Cancel Received Entertainment Audio to Provide Speech Output — *212*

↓

*214* — Loudness of Speech > Loudness Threshold ? — **No** →

↓ **Yes**

*216* — Volume of Entertainment Audio > Predetermined Volume Level ? — **No** →

↓ **Yes**

*218* — Attenuate Entertainment Audio at Predetermined Attenuation Level

*Fig-3*

**EUROPEAN SEARCH REPORT**

Application Number

EP 25 18 5581

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 206 100 419 U (ZHICHE YOUXING TECH CO LTD) 12 April 2017 (2017-04-12) * the whole document * | 1-15 | INV. G10L21/0208 G10L25/78 H03G3/32 |
| X | US 2016/111087 A1 (SRAIL DOUGLAS A [US]) 21 April 2016 (2016-04-21) * the whole document * | 1,10 | |
| A | SIMON GRAF ET AL: "Features for voice activity detection: a comparative analysis", EURASIP JOURNAL ON ADVANCES IN SIGNAL PROCESSING, vol. 15, no. 10, 11 November 2015 (2015-11-11), page 257, XP055337776, DOI: 10.1186/s13634-015-0277-z * section 2 * | 1 | |

TECHNICAL FIELDS SEARCHED (IPC)

G10L
H03G

The present search report has been drawn up for all claims

| Place of search | Date of completion of the search | Examiner |
|---|---|---|
| The Hague | 8 September 2025 | De Meuleneire, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 5581

This annex lists the patent family members relating to the patent documents cited in the above-mentioned European search report.
The members are as contained in the European Patent Office EDP file on
The European Patent Office is in no way liable for these particulars which are merely given for the purpose of information.

08-09-2025

| Patent document cited in search report | Publication date | Patent family member(s) | | Publication date |
|---|---|---|---|---|
| CN 206100419 U | 12-04-2017 | NONE | | |
| US 2016111087 A1 | 21-04-2016 | CN | 105529996 A | 27-04-2016 |
| | | EP | 3012836 A1 | 27-04-2016 |
| | | US | 2016111087 A1 | 21-04-2016 |

EPO FORM P0459

For more details about this annex : see Official Journal of the European Patent Office, No. 12/82